Europäisches Patentamt

European Patent Office

Office européen des brevets

(19)

(11) Publication number: **0 364 189**

**A2**

# EUROPEAN PATENT APPLICATION

(12)

(21) Application number: 89310299.6

(51) Int. Cl.5: **G06F 15/20**

(22) Date of filing: 09.10.89

(30) Priority: 10.10.88 GB 8823747

(43) Date of publication of application:
18.04.90 Bulletin 90/16

(84) Designated Contracting States:
DE ES FR GB IT NL SE

(71) Applicant: **Vickers Shipbuilding &
Engineering Limited
Barrow Engineering Works P.O. Box 12
Barrow-in-Furness Cumbria LA14 1AF(GB)**

(72) Inventor: **Johnston, Terence Michael
73 Saves Lane
Ireleth Cumbria LA16 7HL(GB)**
Inventor: **Williams, Marcus Ronald
Gafia Cottage Highfield
Dalton-in-Furness Cumbria LA15 8JG(GB)**
Inventor: **Wilkins, Andrew
59 Glenridding Drive**
**Barrow-in-Furness Cumbria LA14 4PA(GB)**
Inventor: **Walker, Mark Gerald
124 Friars Lane
Barrow-in-Furness Cumbria LA13 9NU(GB)**
Inventor: **Hoggard, Martin
Heather Bank House Brigsteer
Nr. Kendal Cumbria LA8 8AH(GB)**
Inventor: **Lovell, David Richard
60 Hibbert Road
Barrow-in-Furness Cumbria LA14 5AF(GB)**
Inventor: **Smith, Neil
11 Laurel Drive Holbeck
Barrow-in-Furness Cumbria LA13 0RD(GB)**

(74) Representative: **Overbury, Richard Douglas et
al
HASELTINE LAKE & CO Hazlitt House 28
Southampton Buildings Chancery Lane
London WC2A 1AT(GB)**

(54) **System design tool and method.**

(57) A system design tool and a method for use in system design, by which the behaviour of a complex interactive system can be simulated. The system is represented as a number of interconnected "processes" (e.g. 7,8,14) and each process is provided with an algorithm to model its function and its interconnections (1,2). The processes may be arranged in a layered hierarchical structure (4,6,9) and each process can have functions such as supplying data from a sensor, relaying data or processing data. The algorithms are combined into an overall model of the system, and the system model is supplied with data on initial conditions of the system. The system model (for example, a computer program) is then executed using the data on initial conditions so as to perform a simulation of the system, with additional data being supplied during execution to simulate changes in external conditions affecting the system. The progress of the simulation can be monitored on a display which shows a logic diagram representing at least part of the system, with symbols representing individual processes which change colour, or change in some other way, to show whether the respective process is inactive, transmitting data, processing data or the like. This allows potential bottlenecks or other problem areas in the system to be identified.

The system design tool and method can be applied to a wide range of interactive systems, such as transport systems, telecommunications networks, chemical plant and so forth.

# SYSTEM DESIGN TOOL AND METHOD

The present invention relates to a system design tool, and a method for use in system design, which may be used to optimise the design of a particular system. In this context, a "system" could be an integrated passenger transport system, such as for aircraft in the air, airports, pedestrial routeways, trains, buses, taxis and private cars; or an integrated telephone exchange, e.g. with international, domestic and/or business connections, including in-house company networks; or an integrated control system for a modern warship.

Flow diagrams are well known means of representing a system such as an oil refinery, rail or telephone network, and the like, but as a general rule they represent only the steady state condition, e.g. a flow in litres per hour or the passage of an average number of trains or calls per unit of time. In the real world, fluids can flow in surges and rush hours cause congestion. A static flow diagram cannot accommodate rapid changes in the data flow regimes nor the ramifications of a disruption of the network, such as a train derailment or roadworks.

Logic diagrams are also known in which 'either/or', 'what if?' and other types of decisions may be made. In such a diagram, a single input and the logic flow therefrom can easily be followed. However, when several inputs occur simultaneously, or in rapid succession, causing an interaction between the responses which result, the logic tends to break down. For example, the output from a first location may not be passed onto the receiving one because the receiving location is still processing a concurrent input and all intermediate storage locations are filled. This will effectively 'block' the first location, disrupting the whole logic flow. There is thus a need to be able to follow such a complicated system in a slow animated manner, even though the inputs and responses are occurring at high speed. The solution should ideally be able to indicate visually the sort of responses occurring throughout the system in real time and provide a hard copy of what occurred when for subsequent detailed study. It is also desirable to be able to construct a large number of incident scenarios and combinations of scenarios and thus design the system to be able to accommodate any particular combination of events which might reasonably occur.

According to one aspect of the present invention, there is provided a system design tool, comprising:
simulating means operable to simulate mathematically a complex interactive system, by representing said system as a plurality of interconnected processes, each process being defined by an algorithm which takes into account its basic function(s) and its interconnections with other components, and by carrying out computations to perform all the algorithms in an essentially predetermined combined manner so as to effect a simulation;
data input means operable to feed data to the simulating means before and during said computations to provide information on initial conditions and changes in conditions affecting said system; and
data output means operable during said computations to supply results of said computations to a display, in the form of at least one logic diagram with symbols representing the processes and interconnections, the symbols being dynamically changed in appearance to indicate the progress and results of the simulation.

According to another aspect of the present invention, there is provided a method of simulating mathematically a complex interactive system, for use in system design, comprising steps of:
representing the system as a plurality of interconnected processes;
providing an algorithm for each process which models its function and its interconnections with other processes;
combining the algorithms to produce an overall model of the system;
providing data on initial conditions of the system;
performing computations using computing means on the basis of the model and initial conditions so as to effect a simulation of the behaviour of the system;
supplying the computing means with data on changes in conditions of the system during the course of the computations; and
displaying a diagram representing at least part of the system, having symbols representing the processes and their interconnections, and changing the appearance of the symbols during the course of the computations so as to indicate the progress and results of the simulation.

Thus, the system is broken down into a number of interconnected "processes", in other words separately-identifiable but interacting components of the system.

The algorithms define mathematically the complete function of every process e.g. whether it provides data, accepts and stores data, processes data (and the method by which it is processed) or transfers data to another specified location or any combination of these functions. The interconnections with other components are also specified, e.g. receive data from A and B, receive data from and transfer data to C, etc. In certain cases, the algorithm can define the interrogation of one component by another, for example component D could interrogate component E, causing E to obtain data from F, G and H, process the data and return the answer to D. Interconnections can of course carry instructions as well as data.

Data inputs can include random inputs or human intervention, and processing functions can represent the actions of microprocessors or separate computers.

The user of the system design tool observes the changing appearances of the symbols on the display (e.g. a V.D.U.) so as to monitor the progress of the simulation and to detect trouble spots such as data bottlenecks. In the case of a large system, however, it may be difficult to monitor the whole simulation in this way. Therefore, in a preferred embodiment the processes are arranged in a hierarchical layer structure, wherein a single process in one layer is sub-divided into a number of processes of a lower layer. By viewing the logic diagram for all or part of one layer, the user can observe the system at a desired level of detail.

Often, the system design tool will be used with a view to designing electronic circuitry or a computer system to perform the functions being simulated. It is often advantageous to employ parallel processing techniques in such circuitry or computer systems, and an embodiment of the invention allows parallel processing configurations to be tried out in the simulation. That is, processes can be organised into groups, and the algorithms of one group are performed independently of, and in parallel with, those of another group. The group organisation can be changed in a systematic or random way to try out different configurations.

Typically, the simulation will be carried out on a computer system of adequate capacity. For most applications, this could be a conventional technical mini computer, such as a DEC VAX 8500 series but for larger systems, a mainframe computer such as an IBM 3083 could be required. In this case, the algorithm for each process takes the form of a piece of computer code in a high-level computer language such as ADA. The design tool then combines all the algorithms into one computer program. The computer input file (known as the 'Event List') defines a set of initial conditions for the simulation and this is separately entered once the program has been compiled and linked, thus facilitating repeated changes to the initial conditions (scenario) without rebuilding the software.

As well as the data on initial conditions, information on changes in conditions affecting the system is introduced during the course of the simulation. In the case where a computer system is used for the simulation, this latter type of information will normally be incorporated into the computer input file (Event List). Alternatively, the user could enter data at a terminal of the computer system during the course of the simulation, which would be one way to simulate "human intervention" or a "random" input to the system.

It may be important to simulate the effect of damage upon the system. One embodiment of the invention permits this by incorporating a statistical function into one or more of the algorithms, which can alter its results (i.e. its outputs to other algorithms), perhaps unpredictably, when for example one or more of its data inputs are absent.

The output from the simulator (computer) is used to display the logic diagram(s) and illustrate graphically the progress of the logic in either a free-running time mode or in a series of (computer) time intervals. The appearance of the representations of particular processes on the one, or more, logic diagrams on the display is changed in accordance with the operation being performed by the particular process at that particular time. For example, when a process is not operational, it could be a first colour, when transmitting data - a second colour, when processing data - a third colour, and so forth.

Preferably, the means of display is a colour V.D.U. (visual display unit) with a printer or plotter also provided from which coloured hard copies are obtainable.

Conveniently, there is provided as a further part of the computer program, means to log every unit operation for subsequent use in generating process and data utilisation statistics at the completion of every scenario execution, and also to arrange and display every item of data and signal transfer from the system under test to its 'environment' in a chronological order, on a real time or time interval basis. In this context, 'every unit operation' means every transfer of data, request for data, processing function, etc.

The statistics output provided for each functional process identified in the system, covers analysis of data throughput, data staleness, processing time, number of occurrences of each state for finite state processes, etc. Data throughput is a measure of the particular data-link utilisation (i.e. rate of data transfer) and data staleness provides an indication of the length of time data is available, but remains unused by the receiving process. Preferably the statistics output file and the external data log are displayable on a V.D.U. and obtainable as a hard copy print out.

The hard copies of the Statistics output file and the external data log enable the designer to study in detail how the simulation has proceeded. If there have been any problems, e.g. excessive concentrations of data at one location causing storage and transmission problems, these can be identified and the system design changed accordingly.

By running the program repeatedly with different combinations of inputs, hardware and software to implement the system can be designed to eliminate weaknesses and so guarantee a proper response to a given combination of inputs. In addition, as mentioned, various degrees of failure or damage can be simulated to assess how each degree of failure/damage would affect the response.

One embodiment of the invention will now be explained, by way of example only, applied to the design of the interrelated systems of a modern warship, with reference to the accompanying drawings in which:

Figure 1 is a diagrammatic illustration of some of the major interrelated systems of a modern warship;

Figure 2 is a diagrammatic illustration of the breakdown of one of the major systems shown in Figure 1 into successive levels of detail;

Figure 3 is a diagrammatic representation of a first level of the countermeasures logic hierarchy;

Figure 4 is a diagrammatic representation of a second level 6 of the countermeasures logic hierarchy;

Figure 5 is an overall flow diagram for a software program ('VIEMAS') embodying the present invention

Figure 6 is a flow diagram for a VIEMAS Subroutine EXPANDER;

Figure 7, 8 are flow diagrams for the VIEMAS Subroutine EXECUTOR;

Figures 9-13 are flow diagrams showing the logic of the execution of the VIEMAS Program;

Figures 14 and 15 are diagrammatic illustrations of groupings of processes shown in Figure 2; and

Figure 16 is a histogram showing data flows along data highways as a percentage of maximum capacity.

Before describing the system design tool itself, the systems of a warship will be described first by way of background explanation.

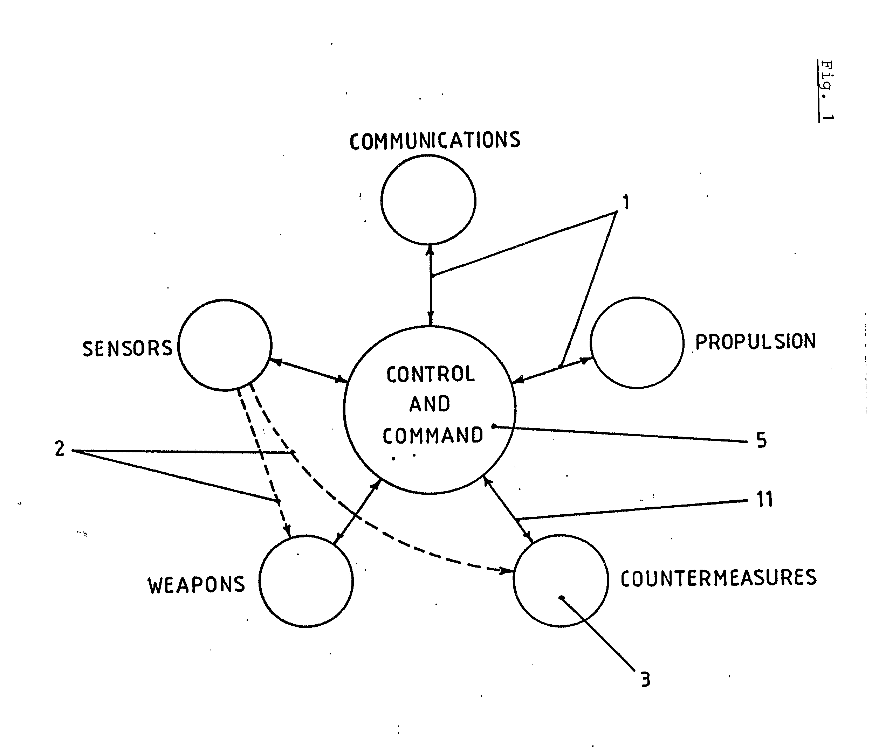

In a modern warship, such as a submarine, all the basic systems are controlled from a single command point. As shown in Fig. 1 by the double-headed radial arrows 1, there is a two-way (primary) traffic in data, for example consisting of an instruction and a response confirming that the instruction has been carried out; though this data could be verbal, the modern trend is that the data flow is electronic in nature. In addition to the radial flows, dashed lines 2 are shown to indicate that there are also data links between, for example, the sensors and weapons system and sensors and countermeasures system. These data flows are shown as only undirectional (secondary), e.g. a sensor warning of a detected hostile presence.

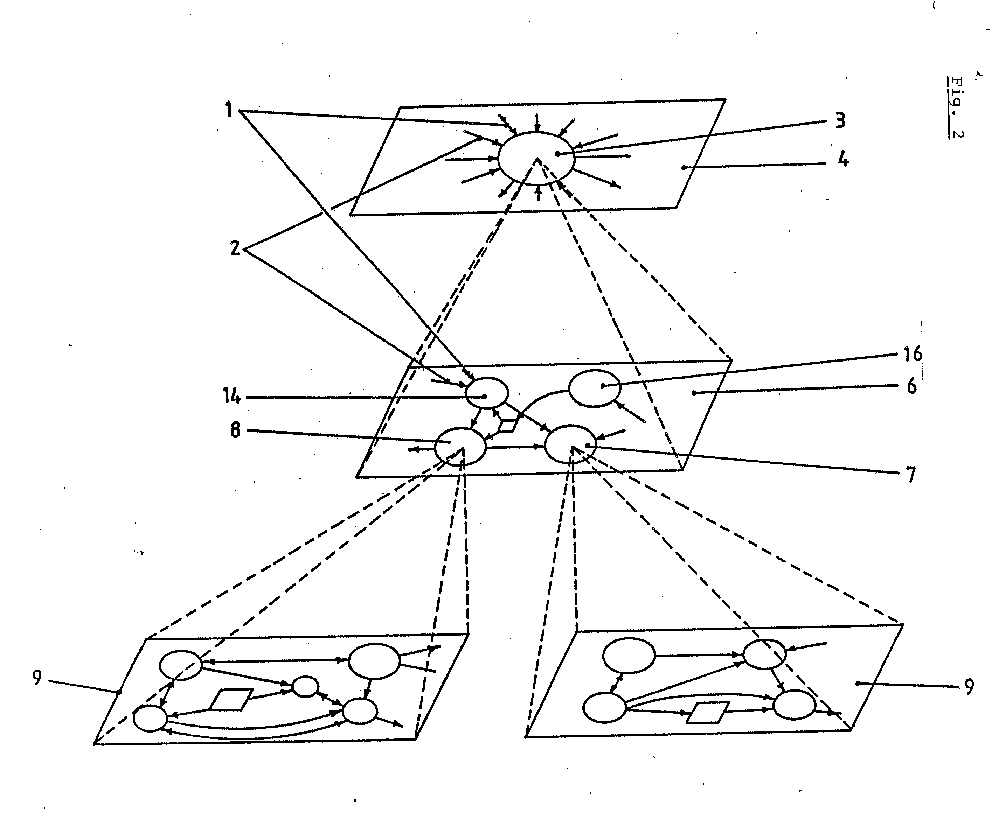

Fig. 1 shows how different systems interface on a macro scale to give the complete control system for the warship (submarine). The radial flows may be considered as primary data and the dashed circumferential flows 2 as secondary data. However, each of the five peripheral systems (and perhaps the command system itself) is itself a complex of data handling processes and control processes which in turn can be arranged in an ordered, logical hierarchy as shown in Fig. 2. The description will now concentrate on the Countermeasures System 3 as an example.

It will be understood that the 'levelled hierarchy' shown in Fig. 2 is only a means of showing the system diagrammatically. The computer always operates at the lowest level (layer), i.e. with all inputs, data transfers, processes, outputs, etc., included as all these functions are present in the program and could become operational at any time. However, a single diagram with this degree of complexity would be too confusing for the reader to appreciate easily. This also applies to the user of the system design tool as explained later.

Figure 2 shows the levelled hierarchical state of the system logic. The first level 4 shows the overall system 3 (as shown on Fig. 1), the two-way input 1 from the Control and Command centre 5, the sensor input 2 and other inputs/outputs (not numbered). Circle 3 represents a complete programmed "process" or component of the system, which processes the various inputs, e.g. 1, 2, to produce a variety of outputs. Many of these outputs would be demands for further information. For example, the first hierarchical subdivision of process 3 is shown on level 6 consisting of four main processes 7, 8, 14 and 16. These are respectively a launch sequence control process, launch countermeasure control process, threat assessment process, and countermeasures allocation process.

Inputs 1 and 2 are actually received by process 14 and cause further outputs to processes 7 and 8 (as shown by unnumbered arrows) and other outputs (not shown). As Fig. 2 shows, each of processes 7, 8, 14 and 16 may have to rely on further processing and sources of information on a third hierarchical level 9. As shown, processes 7, 8, 14 and 16 represent separate logic subsystems consisting of further processes (shown as circles), data stores etc. (shown as rectangles) and inputs/outputs (shown as arrows); intermediate data stores, e.g. hostile contact parameters, are shown between two parallel lines.

Thus there is an arrangement of the logic in which the whole process is activated by an input 1, and using the information available, e.g. data incoming along input 2, process 14 decides what further data is needed and interrogates data sources and processes, e.g. 7 & 8 as required by the programming. The processes, e.g. 7 & 8, repeat this action on level 2 and thence down on to level 3, and so on. Only three levels are shown on Fig. 2 for purposes of clarity, but it will be understood that as many levels as required for as many processes as required can be provided.

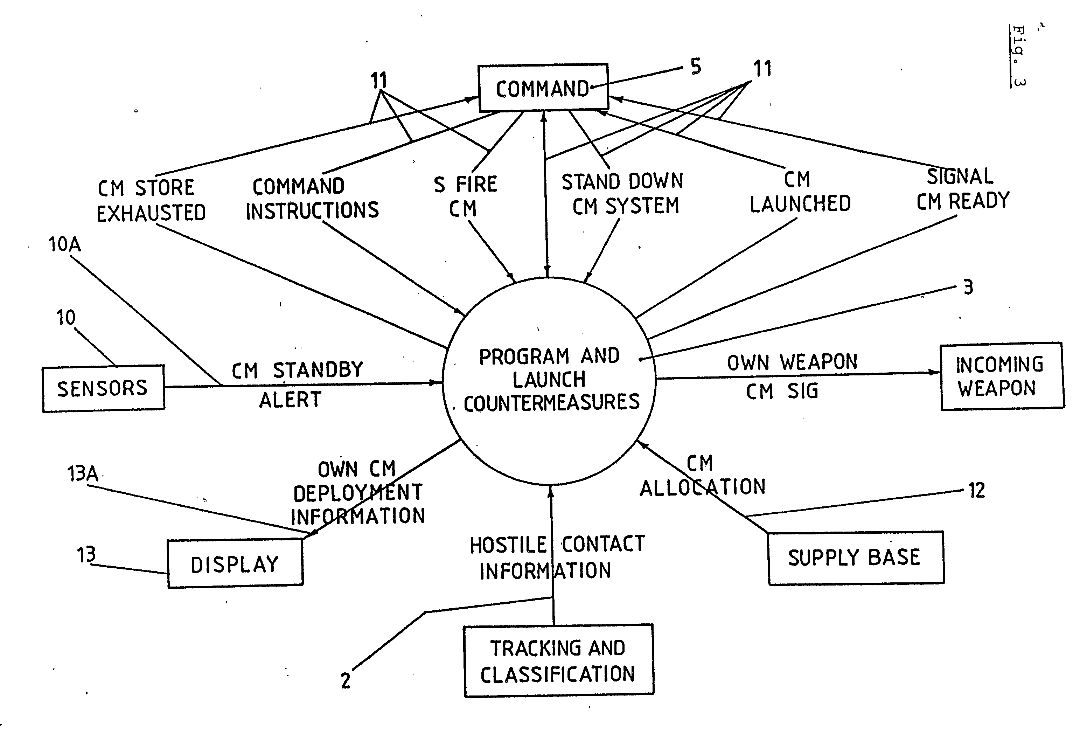

To explain the actual warship system further, a typical series of events will be described. Figure 3 shows the control process 3 and data interconnections on the first level 4 of the countermeasures logic system. As the system will be permanently on line, the threat assessment process 14 will know the state of the C.M. (Counter Measures) store via link 12. This may be considered as time state zero (T = O). At a given time (say T = 1), sensor 10 alerts process 3 via link (sensor alert signal) 10A, that a hostile contact has been identified. Immediate responses 11 to command centre 5 and 13A to a C.M. display 13 indicate that the alert has been registered and a response is being prepared.

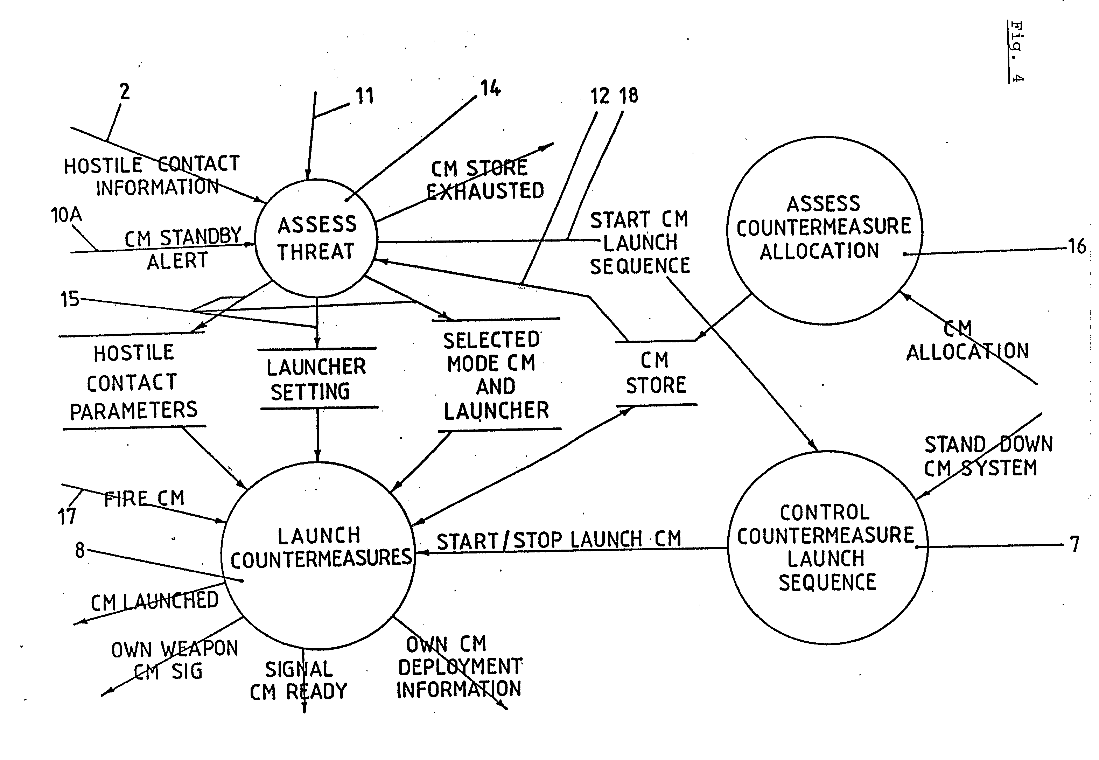

As time passes, e.g. T = 2, 3 etc., more detailed information 2 arrives from the tracking and classification sensors. This confirms that the contact is hostile and is on a course to present an actual threat. As soon as the threat is established by process 14, the control and data processes on levels 6, 9 etc. are brought into action. Fig. 4 shows diagrammatically the control and logic processes on second level 6. The basic countermeasure control process is shown as an interlinking of four separate processes 7, 8, 14 & 16.

Using the hostile contact information 2, process 14 selects the appropriate form of countermeasure, calculates the contact parameters (bearing, speed etc.) and launcher setting, and passes the data to the countermeasures launcher control process 8. A simultaneous alert signal 18 activates launch sequence control process 7. A further process 16 assesses the countermeasures allocation. The other data links to launch control process 8 are self-explanatory, except that it should be noted that signal to fire 17 could be automatically generated, if the countermeasure response was operating in the non-manual mode. 15 indicates a hostile contact response.

The above is a simplified outline of the principle of a countermeasures response. It does not include reference to the various cross-checks prior to firing or the subsequent monitoring of the countermeasure to check that it destroys the target, or make a further response if not. These, and other functions are on lower levels 9, etc. However, it does indicate the large numbers of interdependent signals which must occur in the correct sequence and be acted on at the right time if an effective countermeasures response is to be made. This is only for a single hostile contact. Consider how much more complex must be a real situation in, for example, a dog fight with the submarine weaving about amongst other submarines (friends and foes), attacking and being attacked. There may also be surface warships and the submarine could have sustained damage due to depth charging. Under these circumstances, it is essential that the logic processes are not overwhelmed by the rate of data flow nor that the responses to two different situations are confused. Clearly, if this did occur in practice, there would be no second chance.

The use of a system design tool and method embodying the present invention will now be described using the above example of a warship as the system to be simulated.

Briefly, the system design tool provides a "shell" (usually in the form of a computer program) which can be used to simulate many widely differing types of complex interactive system. The system may either be an existing real system whose behaviour is to be studied, or in the case of system design per se, it may be a proposed design for an electronics, computer system or other real system required to fulfil a complex function such as defending a warship from attack. In either case, before a particular system can be simulated a certain amount of preparation is necessary.

Firstly, the system has to be analysed into components or "processes"; this has already been done in the above explanation of the warship system. Processes can be classified as either of two types: "data processes" which produce, relay, store, process and/or receive data; and "control processes" which process signals to control other processes, for example, by activating them.

More precisely, a "data process" is a function represented by an algorithm which is able to read and manipulate supplied information (i.e. data) which has one or more variable numerical values associated with it.

A "control process", on the other hand, is a function represented as an algorithm comprising at least one 'event state' (see below) with a defined rule(s) for transfer between such states based on the presence of specified input signals. The process can only be in any one state at any given time and transfer from one state to the next is considered to occur instantaneously when the required input signal is present. A control process has no means of manipulating data information, and hence is generally used to 'control' (i.e. enable/disable) the operation of subservient data processes and/or other control processes, as the name implies.

The next stage is to define mathematically the algorithms for all the data processes. This determines how each process responds to the range of possible inputs e.g. whether data is transferred, stored or used in calculations which generate new output flows to initiate further process(es), or combinations of these responses. Algorithms are also defined for all the control processes, but these may be more complex as they normally include 'event states'.

An 'event state' can be defined as a state of a control process, which reflects the state of the system, or part thereof, as a single definable mode of operation. Specific events (i.e. signals) within the system, cause transition from one event state to another, in accordance with the algorithm defined for the relevant control process. Each transition to a new event state, occurring in either a predetermined or random manner, causes the relevant process to produce an output.

These first two stages will normally be carried out manually, by people highly familiar with the particular system to be simulated.

The design tool then combines all the algorithms into a single, unified entity representing the whole system. More specifically, the design tool will normally take the form of a computer program to which the algorithms are added as sections of computer code; these are compiled and linked to form a new program specific to the system to be simulated.

Then, to use the resulting program, the initial parameters are first set, e.g. number of each type of countermeasure, operating conditions and so forth, to define a particular "scenario" of operation of the system, and the simulation is then executed (the program is run). For example, suppose in the case of the "warship" system, the scenario is such that at a time T = 0, an input equivalent to a hostile contact is made. The program then generates the internal logic reactions to the external influence. Computer graphics are used to illustrate different levels 4, 6, 9 (Fig. 2) of the system and the type of process occurring can be identified by colour coding, e.g. a first colour to indicate inactivity, a second colour to indicate data transmission, a third colour to indicate processing of data etc.

In a complex system, as already mentioned the complete logic diagram would be too detailed for the user to appreciate properly, and therefore he may select a logic diagram for a particular level or part of a level for display.

As many processes may be occurring simultaneously, the software preferably includes means of logging all the data transfers, control processes and actions resulting in order to provide a statistical record so that a subsequent print-out may be studied in detail to pinpoint weak points in the whole system design.

In the example of a warship, as well as the various logic subsystems shown in Fig. 2, certain processes, eg. threat assessment 14, could also be performed manually by an operator at a V.D.U. In practice, threat assessment 14 could be any one of:-

    i) Fully manual assessment

    ii) Fully automatic computer assessment

    iii) Fully automatic computer assessment with manual override The system design tool can be provided with a multiposition selector mechanism (i.e. mechanical or software switching) to choose which of the three types of system architecture is required.

Thus, the course of the simulation is displayed visually by the colour changes on diagrams such as those in Figs 3 and 4. Additional external inputs to the system under test may be provided at any subsequent time and the resulting self-perpetuating complex interreaction studied and analysed.

The advantage of the colour changes is that the computer display shows the progress of the data traffic through the interactive system. This is a significant advance in that the logic process can be displayed in pseudo 'real time', i.e. a slowed down version (slowed down deliberately if necessary so that the user can observe the changes more easily) of the actual operation of the system. Previously such processes could be studied only as a series of logic diagrams on separate sheets of paper; while this would be practicable for a single input, it would not be so for multiple inputs at randomly overlapping time intervals.

The significance of this advance may be appreciated by comparing a series of photographic slides with a cine film. Each slide represents one unchanging instant of time whereas the cine film shows actual changes in real time. By running the cine film in slow time, the detail of the changes becomes apparent.

The hard copy of the statistical analysis of data transfers, control process actions etc. allows the system designer to study the detailed throughput and utilisation of processes, together with the data loading on any of the datalinks and so identify actual, or potential, problem areas.

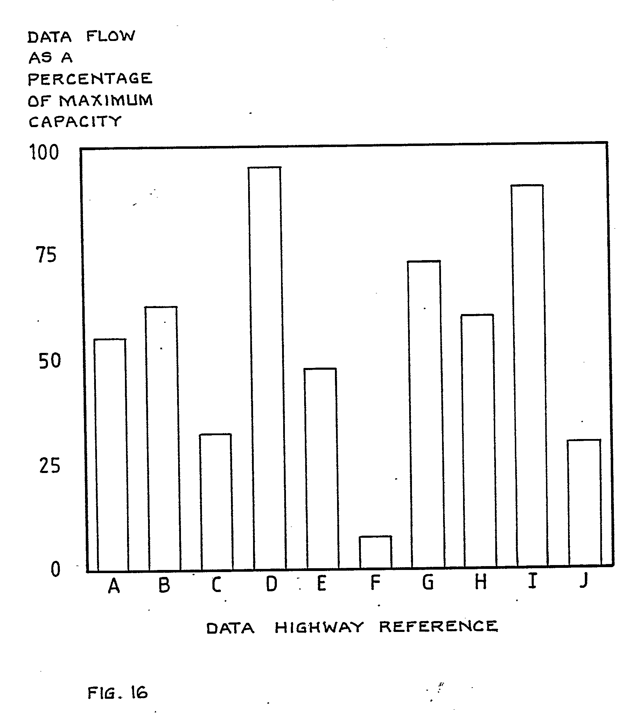

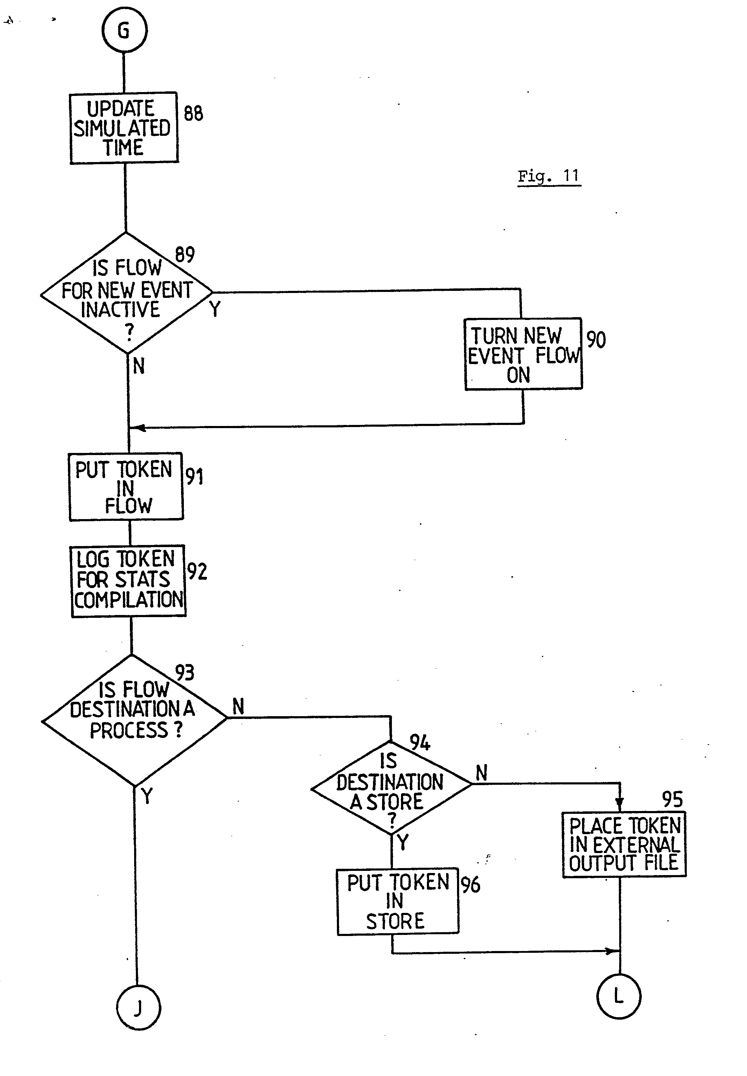

The statistical data may be presented on a user-friendly basis, in addition to the hard copy listing. For example, as one of the principle objects of system design is to design a data transfer system which will never be overloaded, the data flow on each interconnection or "highway" could be represented pictorialy on a V.D.U. screen as a histogram to indicate the data flow as a function of maximum capacity, e.g. as shown in Fig. 16. The same technique could be used to illustrate the relative "staleness" of data, i.e. the length of time for which data is unused.

Referring to Fig. 16, the vertical axis would represent the amount of data flowing as a percentage of maximum capacity for that data highway.

The horizontal axis would refer to a number of data highways (denoted A to J). In the histogram shown, highways D and I are rapidly approaching maximum capacity, while F is very little used. Such data, if it was representative of the norm, and not just a special case, would indicate that the carrying capacity of data highways D and I should be increased and that of F, reduced. Thus, one of the principle uses of the design tool is to determine hardware requirements such as these for a practical electronics or computer system to be installed in the field (in the above example, on the warship).

In a real design process the designer can run the simulation (program) repeatedly to simulate different scenarios, e.g. with differing combinations of inputs, and differing time intervals between each input, to assess the response to particular sets of conditions and hence determine for which scenarios the system would fail to cope. From the display and print out, he can identify particular 'bottlenecks' in the data linkages or process capacities and, by improving the hardware capability at these points, extend the range of operation of the system. The "animated" display of changing symbols can be turned off to reduce execution time if desired, which is advantageous when the simulation is run several times, and the statistical analysis relied upon for assessing the results.

Such a design tool can be used to compare alternative items of hardware for use in implementing a particular process in a practical system, by inputting the appropriate algorithm and running the program. Alternatively, by deciding what algorithm was best for a particular process, the 'ideal' component can be specified and thus manufactured.

A further use of the design tool is to simulate different levels of damage which could be sustained and yet still allow the system to operate to an acceptable level of efficiency. In this case, the algorithms for selected data and/or control processes would be effectively removed from the program.

One way of simulating damage is to include a statistical factor in the process algorithms. For example, the algorithm of a process will normally follow precise mathematical rules so that an algorithm may require inputs A, B and C before producing an output D; if, say, damage has occurred and input B is not available, this input cannot be registered and hence there can be no output D. A statistical function could be built-in, to cause the process to produce output D if only, say, two out of the three inputs were present but with reduced information content and accuracy. A time delay could be included, if required, so that the statistical function would become operative only after a certain number of time intervals had elapsed.

Further uses of the design tool include modelling transfer of data between intercommunicating systems, e.g. via links 1 (Fig. 1). Such data links may be either simplex, half duplex or duplex in nature. The data to be transferred can be arranged in priority groupings, e.g. first, second, third priority. The data is then transferred between interface ports in priority order and at a transfer rate determined by the preset parameter values of the particular interface. This can prevent the data links becoming blocked by unimportant details when essential information is held up, and by analysis of the utilisation statistics of the interface under varying conditions, an optimum interface type can be specified. Thus the design tool may be used on either a micro-basis, to optimise the design of a particular system, or parts of it, or on a macrobasis, to optimise the design of linkages between whole systems.

This concept of using a computer programming principle to design (and subsequently operate) complex interactive systems is known as an "Architecture Modelling Tool".

One of the features of modern computers is their ability to conduct 'parallel processing' and thus speed up and simplify the overall computation. As can be seen in Fig. 2, the large number of separate calculations required at lower levels, e.g. 6 and 9, make parallel processing an ideal technique to simulate using the system design tool. A further feature of "Architecture Modelling" is to optimise how the interactive processes on each level are grouped together, so that the necessary parallel processing can be carried out in the most effective manner.

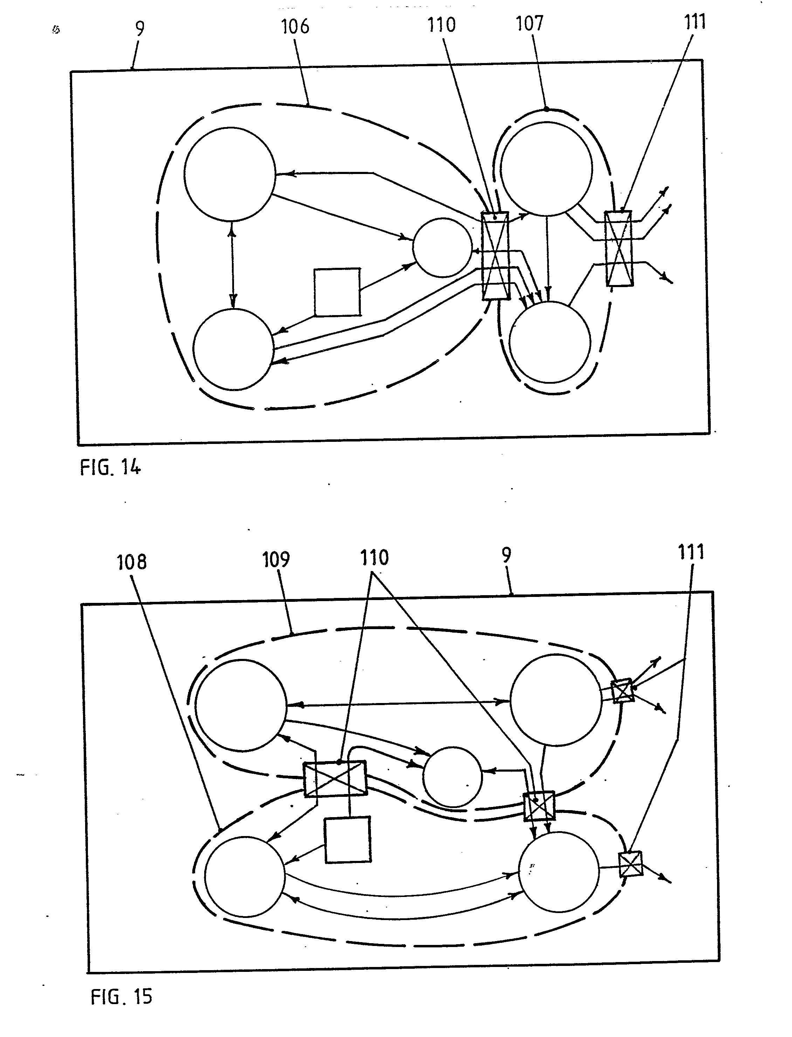

In Fig. 2, a number of processes and flows are shown on levels 6 and 9 bounded by rectangles. This may be further simplified by sub-dividing the number of these processes into smaller groupings as shown in Figs. 14 and 15 (which refer to the level 9 rectangle shown at the left on Fig. 2); the groups shown in each dashed balloon 106, 107, or 108, 109 are calculated as separate entities before being included in the rest of the computation. This principle is analogous to the use of brackets in conventional mathematics. A 'grouping' could, of course, consist of any number of processes down to only one single process, if required. The data transference between groupings 106 and 107 or 108 and 109 would be via interfaces 110, and to other groupings, via interfaces 111. On Fig. 15, two interfaces 110 are shown. Though two interfaces could be used in particular cases for computing or electronic reasons, they are used here to avoid the figure becoming over-complicated with criss-crossing data flow arrows.

Figures 14 and 15 refer to the left hand section of level 9 in Fig. 2. As an optional feature of the invention, when used in the system design mode, the calculation may be repeated for different groupings, selected either in a preprogrammed or random manner. By comparison of the actual computing times and inspection of the statistics files, the optimum pattern of groupings may be determined.

This is thus a further important feature of the way in which the tool may be used at the basic system design stage.

One of the other advantages of the 'grouping' philosophy is that the variety of architecture thus provided for modelling can assist the designer to define and specify the system and its interrelationships in a better way. Also, the resulting model can be easier to understand physically and the resulting hardware easier to build, i.e. particular groups, or numbers of groups, can be confined to a single printed circuit board. This can have significant advantages in terms of commercial security when all or part of the manufacture has to be subcontracted, as different circuit boards can be manufactured by different suppliers. A system designed on a grouping basis may also be updated more easily than one not so designed.

The man skilled in the art will appreciate how the design tool described hereinbefore may be used in the optimisation of other interactive systems such as telecommunications, transport networks (e.g. road, rail, air and sea), automatic letter sorting, control of chemical plant complexes, computerised distribution systems etc.

To explain more fully the principle and mode of operation of the system design tool, the flow diagram of a particular software embodiment of the system design tool (known as VIEMAS) will now be described. The standard shapes of symbols are used for the diagrams, i.e. a rectangle represents an action and a diamond is a yes/no decision.

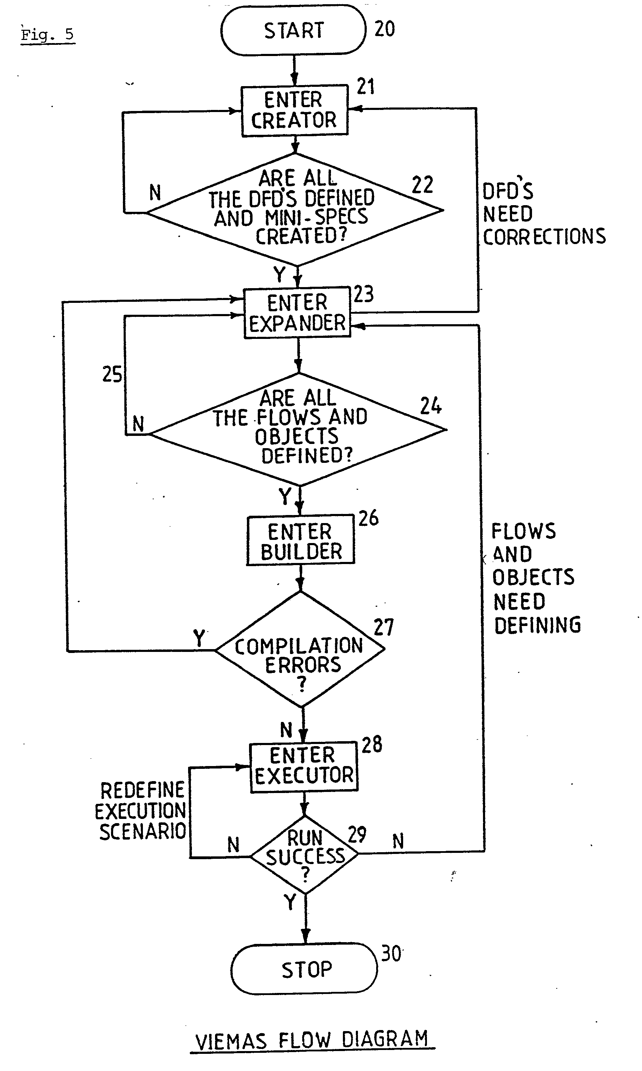

The overall flow diagram is shown in Fig. 5. As will be seen, the overall program includes subroutines called "CREATOR", "EXPANDER", "BUILDER" and "EXECUTOR" whose function is explained below. The logic is as follows.

20 Start

21 CREATOR includes provision for the definition and amendment of the basic layout of the system map (i.e. Figs 2-4) for the particular system under consideration, e.g. countermeasures response. [Each graphics section (e.g. Figs. 3,4) is given a DFD number.]

22 Check on CREATOR 21 and return if error detected.

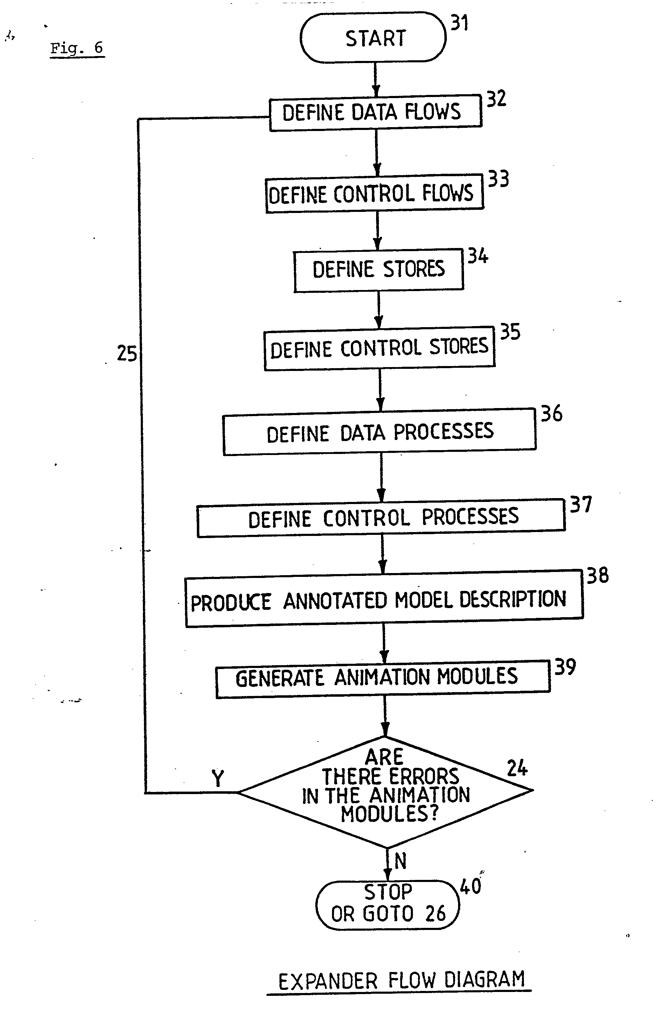

23 EXPANDER is described later with reference to Fig. 6.

24 Check on EXPANDER 23 and return 25 if error detected.

26 BUILDER is the program which translates the algorithms for each data and control process and converts them into machine code. Also included are the supporting subroutines to run the graphics, compute the statistical data, etc.

27 Check for compilation errors.

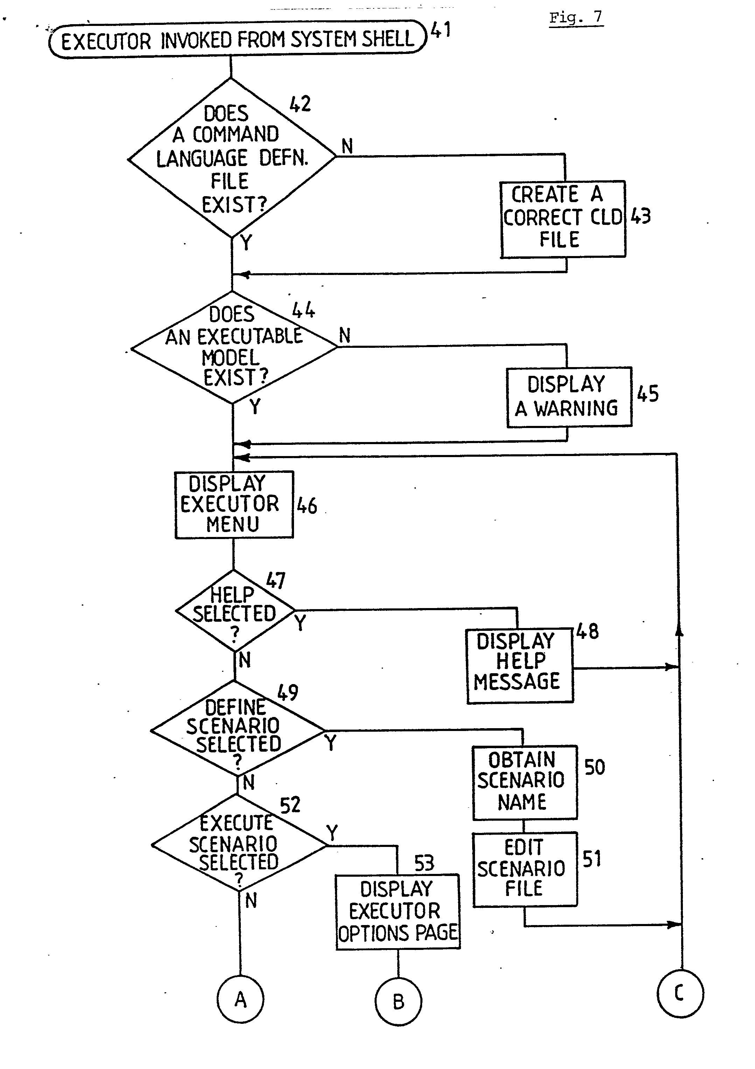

28 EXECUTOR is described with reference to Figs. 7, 8 and 9-13.

29 Program run. Returns to EXPANDER or EXECUTOR if run is unsuccessful.

30 Stop.

The EXPANDER 23 section of the program is shown on Fig. 6 and the logic is:-

31 Start.

32 The data flows, e.g. 12, 13A (Fig. 3) are defined in an input routine.

33 The control flows, e.g. 17, 18 (Fig. 4) are similarly defined.

34,35 The same procedures are repeated for the Stores.

36,37 The same procedures are repeated for the data and control processes, e.g. 16 and 7 respectively.

38,39 Using the above data, the animation modules (Figs. 3,4) are defined in the computer and generated.

24 Check on the amination modules and return along loop 25 if error detected.

40 Stop or GOTO 26 depending on how VIEMAS is being operated.

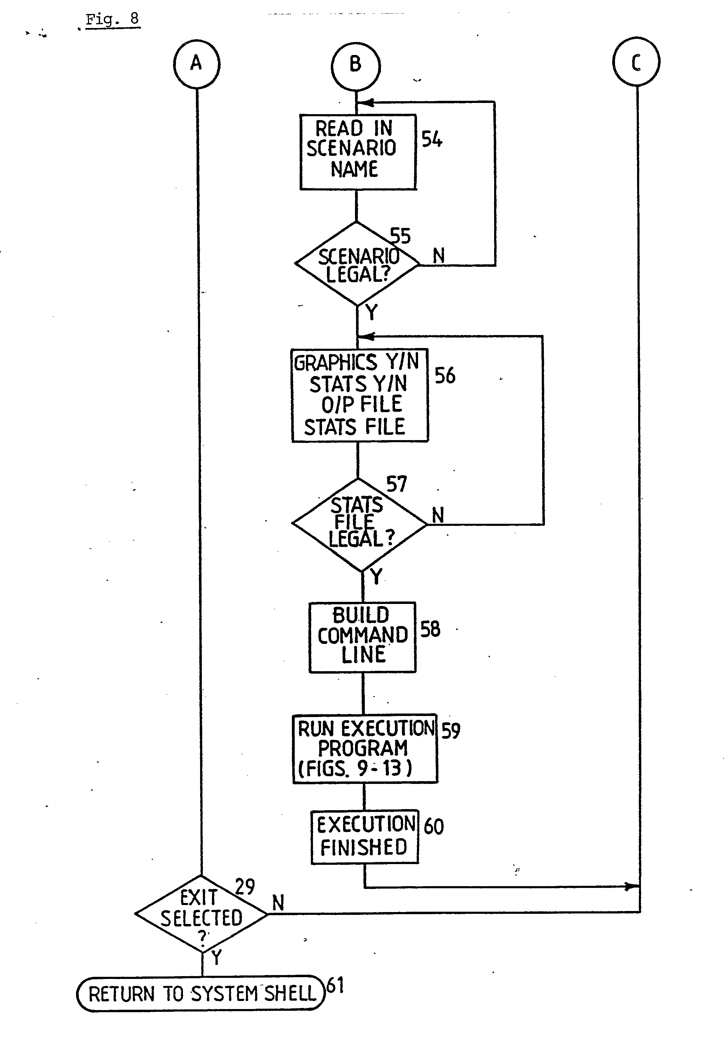

The EXECUTOR is the heart of the program and allows the operator to exercise a range of options over how VIEMAS is run. The flow diagram is shown as a continuation on Figs. 7-8 (setting up) and 9-13 (running). The logic for setting up the program is (Figs. 7,8):-

41 Call EXECUTOR from main program.

42,44 Checks that system is ready to run, i.e. that a viable and fully defined model is present. Errors detection is indicated 43, 45.

46 EXECUTOR menu displayed. There are three basic options - 'help' (for advice on format of user response) 47, 48; to define a new Scenario or edit an existing one 49, 50, 51; or to run an existing Scenario 52. If none are selected, the run ends 29, 61.

53 EXECUTOR options displayed. (Symbols A, B and C indicate continuation onto Fig. 8).

54 Scenario name read in and checked 55. The scenario file contains the model inputs and the times at which they occur.

56 Options to run with graphics and/or statistics; output file and statistics file, generation requirements. (These may be displayed or printed following run execution). The use of the graphic option slows down the program execution by a factor of approximately 20, dependent on the specific display hardware used.

57 Statistics file check (if selected).

58 VIEMAS will prepare for program execution, based on the previously entered run definition information (steps 54 & 56).

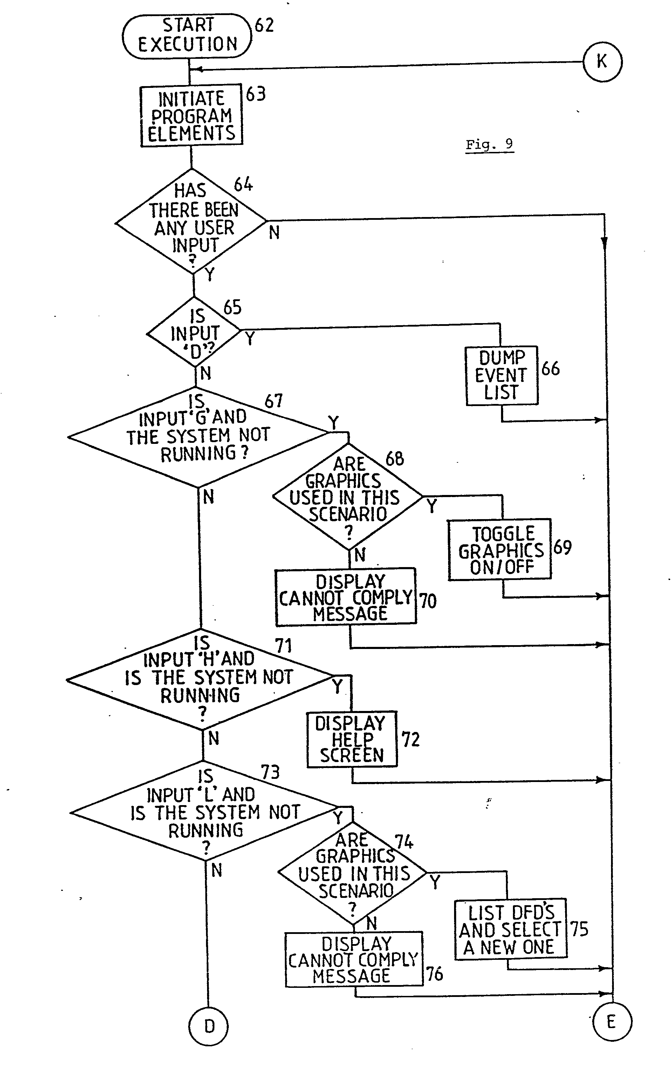

59 EXECUTOR run (see Figs. 9-13).

60 Run finished and return to 46 either to run a different scenario 54, or the same basic scenario with revised inputs/times 50/51 or exit 29, 61.

The actual execution of VIEMAS as a whole, i.e. once CREATOR and EXPANDER are complete and the EXECUTOR invoked, is as shown in Figs. 9-13.

The logic is:-

62 Start execution.

K Indicates return from the end of the program for a rerun.

63 Initiate program.

64 There are a series of possible user inputs, designated by letters D,G,H,L,P,R,S,X,Q. The logic considers each one in turn.

65 Input D- Display event list 66, i.e. the input parameters to the scenario arranged in time order, together with internal events generated during the run and awaiting actioning. The next event to be actioned is always at the top of the list. As the run proceeds, events are removed from the top of the 'stack' and processed. Resultant output events generated are inserted at the appropriate time position in the event list.

67 Input G- Graphics selection - if not operational, function 68, 69 and 70 will highlight with the problem. Use of graphics can result in a twenty fold increase in the program run time.

71 Input H - Help option, only available in 'paused' mode 77, allows function 47 to be used 72.

73 Input L - Allows a change of "window", i.e. - which graphics section (DFD) of the overall model is displayed. This option is available only in the paused mode 77. Items 74, 75 and 76 are to provide this option, i.e. check graphics have been selected 74 and list DFDs 75.

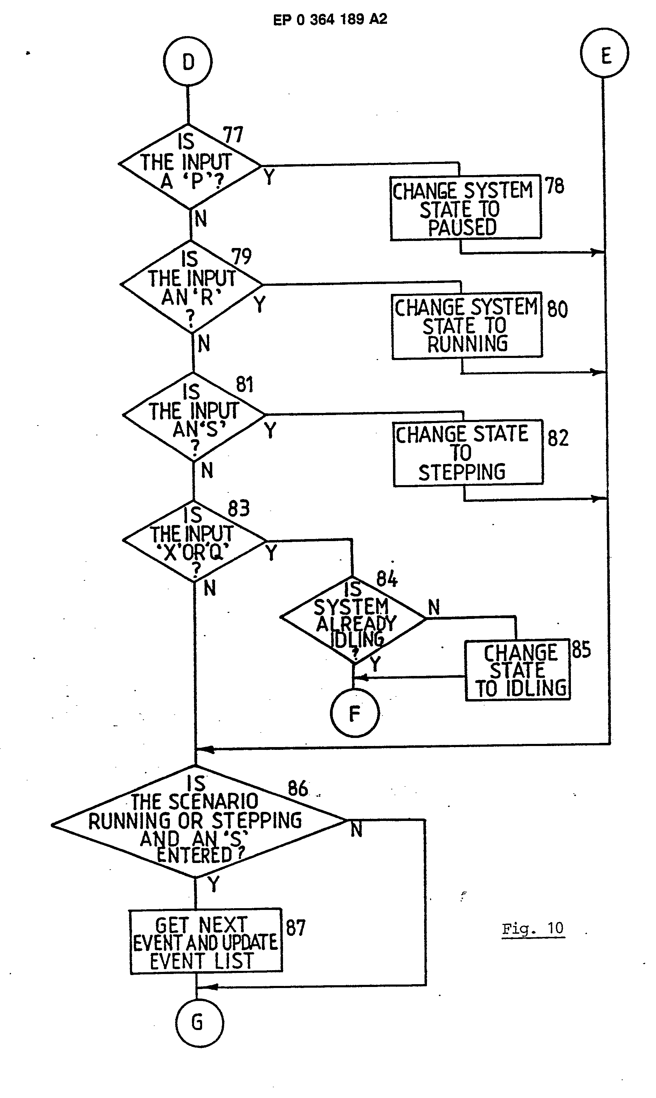

D,E Continuation onto Fig. 10.

77 Input P. Pauses program 78.

79 Input R - Runs program 80 and overrides Pause 78.

81 Input S - Runs program in a timed stepwise manner 82, i.e. equivalent to a frame-by-frame video or film projection.

83 Input X - Exit from program F but retains data on file. Input Q - Quit (or abort) program with no results saved.

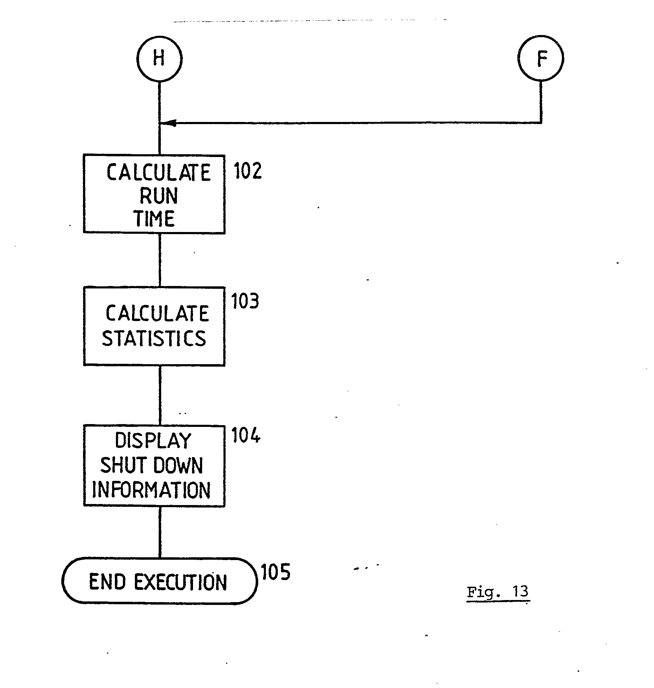

F Continuation to Fig. 13.

86 Check on whether stepping mode 82 or running mode 80 operational.

87 Move event list (see 65,66).

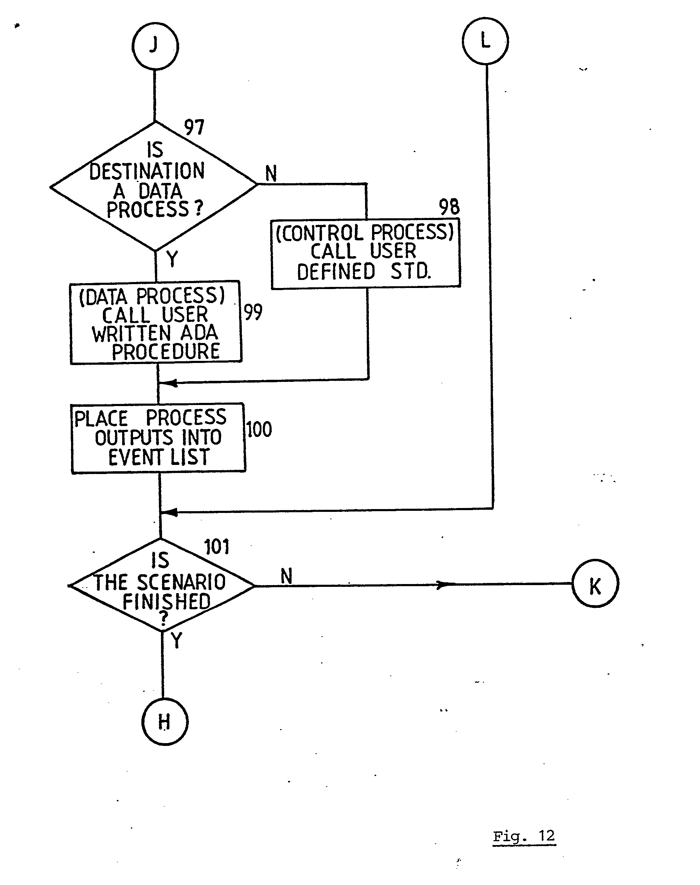

G Continuation to Fig. 11.

88 Update of simulated time.

89 Check whether flow corresponding to new event (see 65,66) is inactive (i.e. it does not already have an unprocessed event waiting) and introduce into program if so 90.

91 New event incorporated.

92 New event logged in statistics file.

93 Check whether new event destination is a process. If yes, GOTO 97, if no GOTO 94.

94 Check whether new event destination is a store. If yes, record in store 96; if no, file in output 95.

J,L Continuation to Fig. 12.

97 Check whether new event destination is a data process. If yes, call appropriate algorithm procedure (written in Ada language) 99 from BUILDER file 26. If no (i.e. destination is a control process), call appropriate algorithm 98 from BUILDER file 26. Both the data and control process algorithms have been defined mathematically by the program writer/user to govern the activity for each data, 16, 14 or control 7 process.

100 Record process outputs at the appropriate time position in the event-list. The process outputs are time-tagged as part of the process algorithm to simulate a representative processing time taken by the equipment being modelled by the algorithm.

101 Check to see whether scenario is completed, i.e. whether the even list (65,66) is empty. All input events and all resulting actions are then complete. If not, the return is via loop K to 63. If yes, GOTO 102.

H Continuation to Fig. 13.

102 Calculation of run time (real elapse time).

103 Preparation of statistics output.

104 End of run display data.

105 Stop.

In summary, therefore, the present invention provides a system design tool and a method for use in system design, by which the behaviour of a complex interactive system can be simulated. The system is represented as a number of interconnected "processes" and each process is provided with an algorithm to model its function and its interconnections. The processes may be arranged in a layered hierarchical structure and each process can have functions such as supplying data from a sensor, relaying data or processing data. The algorithms are combined into an overall model of the system, and the system model is supplied with data on initial conditions of the system. The system model (for example, a computer program) is then executed using the data on initial conditions so as to perform a simulation of the system, with additional data being supplied during execution to simulate changes in external conditions affecting the system. The progress of the simulation can be monitored on a display which shows a logic diagram representing at least part of the system, with symbols representing individual processes which change colour, or change in some other way, to show whether the respective process is inactive, transmitting data, processing data or the like. This allows potential bottlenecks or other problem areas in the system to be identified.

The system design tool and method can be applied to a wide range of interactive systems, such as transport systems, telecommunications networks, chemical plants and so forth.

## Claims

1. A system design tool, comprising:
simulating means operable to simulate mathematically a complex interactive system, by representing said system as a plurality of interconnected processes, each process being defined by an algorithm which takes into account its basic function(s) and its interconnections with other components, and by carrying out computations to perform all the algorithms in a predetermined combined manner so as to effect a simulation;
data input means operable to feed data to the simulating means before and during said computations to provide information on initial conditions and changes in conditions affecting said system; and
data output means operable during said computations to supply results of said computations to a display, in the form of at least one logic diagram with symbols representing the processes and interconnections, the symbols being dynamically changed in appearance to indicate the progress and results of the simulation.

2. A system design tool as claimed in claim 1, wherein a said algorithm defines mathematically the complete function of its respective process, including functions of input, output and/or storage of data and any function of processing data, and defines all the interconnections of the process with other processes.

3. A system design tool as claimed in claim 2, wherein a said algorithm also defines the interrogation of another process by its respective process.

4. A system design tool as claimed in claim 1, 2 or 3, wherein said processes are arranged in a layered structure, in which processes of one layer are expressed in a more detailed form as pluralities of processes of a lower layer, and wherein said data output means is operable to supply for display a different said logic diagram for each layer, the logic diagram to be displayed being selectable so that the progress and results of the simulation can be monitored at a desired level of detail.

5. A system design tool as claimed in claim 4, wherein said simulating means comprises means for grouping processes on a given layer into one or more groups, and wherein the simulating means is operable to perform the algorithms of processes in a group independently of, and in parallel with, processes of another group for simulating a parallel processing configuration of the system; said grouping means being operable to select alternative groupings in a preprogrammed or random manner so as to simulate the effects of different parallel processing configurations.

6. A system design tool as claimed in any preceding claim, wherein said simulating means is operable to combine all the algorithms into a single computer program independent of initial conditions, and wherein said data input means is operable to supply said information on initial conditions of the system to said simulating means after said single computer program has been formed, whereby different scenarios of operation of the system may be readily simulated.

7. A system design tool as claimed in any preceding claim, wherein said information on changes in conditions affecting said system, provided by said data input means, includes random changes and/or events, and/or results of human intervention in a given process, said information being provided before and/or during the course of said simulation.

8. A system design tool as claimed in any preceding claim, wherein said simulating means includes means for simulating the effect of damage upon a process and/or interconnection by varying the operation of an algorithm according to a statistical function and/or by effective removal of the algorithm representing that process and/or interconnection from the program.

9. A system design tool as claimed in any preceding claim, wherein said data output means is arranged to supply results of said computations to said display in a free-running time mode, whereby the symbols of the displayed logic diagram are continuously dynamically changed.

10. A system design tool as claimed in any one of claims 1 to 8, wherein said data output means is arranged to supply results of said computations to said display at a series of time intervals representing successive time periods of the simulation, whereby the symbols of the displayed logic diagram are updated at each time interval.

11. A system design tool as claimed in any preceding claim, wherein each symbol representing a process on the displayed logic diagram can take one of at least three different appearances, a first appearance indicating a non-operational state of the process, a second appearance indicating that the process is processing data, and a third appearance indicating that the process is transmitting data.

12. A system design tool as claimed in claim 11, wherein said appearances are distinguished by different colours.

13. A system design tool as claimed in any preceding claim, wherein the simulating means includes logging means for recording events occurring during the simulation, including transfers of data, requests for data, and processing of data, and wherein said data output means is operable after the simulation is completed to supply the contents of said logging means to said display for diagnostic purposes.

14. A system design tool as claimed in any preceding claim, further comprising statistics generating means operable to process the contents of said logging means to provide statistics on the simulation, including statistics on the utilisation of interconnections, and operable to supply said statistics to said data output means.

15. A system design tool as claimed in claim 14, wherein said statistics generating means and data output means are arranged to produce said statistics in a graphical or pictorial form.

16. A system design tool as claimed in any preceding claim, further comprising printing or plotting means operable to receive the output of said data output means, for producing a permanent record of the simulation.

17. A method of simulating mathematically a complex interactive system, for use in system design, comprising steps of:

representing the system as a plurality of interconnected processes;

providing an algorithm for each process which models its function and its interconnections with other processes;

combining the algorithms to produce an overall model of the system;

providing data on initial conditions of the system;

performing computations using computing means on the basis of the model and initial conditions so as to effect a simulation of the behaviour of the system;

supplying the computing means with data on changes in conditions of the system during the course of the computations;

displaying a diagram representing at least part of the system, having symbols representing the processes and their interconnections, and changing the appearance of the symbols during the course of the computations so as to indicate the progress and results of the simulation; and

producing an output of the results of the whole simulation.

Fig. 1

COMMUNICATIONS

SENSORS

PROPULSION

CONTROL AND COMMAND

WEAPONS

COUNTERMEASURES

EP 0 364 189 A2

Fig. 2

EP 0 364 189 A2

Fig. 3

COMMAND — 5    11

11

CM STORE EXHAUSTED
COMMAND INSTRUCTIONS
S FIRE CM
STAND DOWN CM SYSTEM
CM LAUNCHED
SIGNAL CM READY

10A

10

SENSORS    CM STANDBY ALERT

PROGRAM AND LAUNCH COUNTERMEASURES

OWN WEAPON CM SIG    INCOMING WEAPON

3

13A

OWN CM DEPLOYMENT INFORMATION

CM ALLOCATION    12

13    DISPLAY

HOSTILE CONTACT INFORMATION

SUPPLY BASE

2

TRACKING AND CLASSIFICATION

Fig. 4

Fig. 5

START )20

ENTER CREATOR )21

ARE ALL THE DFD'S DEFINED AND MINI-SPECS CREATED? )22

N

Y

DFD'S NEED CORRECTIONS

ENTER EXPANDER )23

ARE ALL THE FLOWS AND OBJECTS DEFINED? )24

25

N

Y

FLOWS AND OBJECTS NEED DEFINING

ENTER BUILDER )26

COMPILATION ERRORS ? )27

Y

N

ENTER EXECUTOR )28

REDEFINE EXECUTION SCENARIO

RUN SUCCESS ? )29

N

N

Y

STOP )30

VIEMAS FLOW DIAGRAM

EP 0 364 189 A2

Fig. 6

START  ]31

DEFINE DATA FLOWS  ]32

DEFINE CONTROL FLOWS  ]33

DEFINE STORES  ]34

DEFINE CONTROL STORES  ]35

DEFINE DATA PROCESSES  ]36

DEFINE CONTROL PROCESSES  ]37

PRODUCE ANNOTATED MODEL DESCRIPTION  ]38

GENERATE ANIMATION MODULES  ]39

ARE THERE ERRORS IN THE ANIMATION MODULES?  24

Y

N

STOP OR GOTO 26  )40

25

EXPANDER FLOW DIAGRAM

Fig. 7

Fig. 8

(A)          (B)          (C)

```
        ┌─────────────┐
        │  READ IN    │
        │  SCENARIO   │ 54
        │    NAME     │
        └─────────────┘
               │
             ╱   ╲    55
           ╱ SCENARIO╲   N
          ╱  LEGAL?   ╲─────┐
           ╲         ╱      │
             ╲     ╱        │
               │ Y          │
        ┌─────────────┐     │
        │GRAPHICS Y/N │     │
        │ STATS Y/N   │ 56  │
        │  O/P FILE   │     │
        │ STATS FILE  │     │
        └─────────────┘     │
               │            │
             ╱   ╲  57       │
           ╱ STATS ╲   N     │
          ╱  FILE   ╲────────┘
          ╲ LEGAL? ╱
             ╲   ╱
               │ Y
        ┌─────────────┐
        │   BUILD     │
        │  COMMAND    │ 58
        │   LINE      │
        └─────────────┘
               │
        ┌──────────────┐
        │RUN EXECUTION │ 59
        │  PROGRAM     │
        │ (FIGS. 9-13) │
        └──────────────┘
               │
        ┌─────────────┐
        │ EXECUTION   │ 60
        │ FINISHED    │
        └─────────────┘
               │
```

       ╱   ╲  29
     ╱ EXIT  ╲   N
    ╱SELECTED ╲──────────────────→
     ╲   ?   ╱
       ╲   ╱
         │ Y

( RETURN TO SYSTEM SHELL )⁶¹

Fig. 9

Fig. 10

**J**

97
IS
DESTINATION
A DATA
PROCESS ?

N

98
(CONTROL PROCESS)
CALL USER
DEFINED STD.

Y

(DATA PROCESS)
CALL USER
WRITTEN ADA
PROCEDURE
99

PLACE PROCESS
OUTPUTS INTO
EVENT LIST
100

**L**

101
IS
THE SCENARIO
FINISHED
?

N

**K**

Y

**H**

Fig. 12

Fig. 13

FIG. 14

FIG. 15

DATA FLOW
AS A
PERCENTAGE
OF MAXIMUM
CAPACITY

DATA HIGHWAY REFERENCE

FIG. 16

Fig. 11

G

UPDATE
SIMULATED
TIME — 88

IS FLOW
FOR NEW EVENT
INACTIVE
? — 89

Y → TURN NEW
EVENT FLOW
ON — 90

N

PUT TOKEN
IN
FLOW — 91

LOG TOKEN
FOR STATS
COMPILATION — 92

IS FLOW
DESTINATION A
PROCESS ? — 93

N → IS
DESTINATION
A STORE
? — 94

N → PLACE TOKEN
IN EXTERNAL
OUTPUT FILE — 95

Y

PUT TOKEN
IN
STORE — 96

Y

J

L